# EUROPÄISCHE PATENTANMELDUNG

(11) **EP 0 681 369 A1**
(43) Veröffentlichungstag der Anmeldung: **08.11.1995**
(21) Anmeldenummer: 95105593.8
(22) Anmeldetag: 13.04.1995
(51) Int. Cl.: H03K 17/95

(54) **Magnetischer Schalter**

(30) Priorität: 06.05.1994 DE 4416073
(71) Anmelder: VACUUMSCHMELZE GMBH, D-63450 Hanau (DE)
(72) Erfinder: Preusse, Norbert, Dr., D-63755 Alzenau (DE)
(74) Vertreter: Fuchs, Franz-Josef, Dr.-Ing.

(57) **Zusammenfassung**

Ein magnetischer Schalter, der bei Überschreiten einer bestimmten Schaltkraft mit extrem kleinem Schaltweg auskommt, besteht aus einem magnetfeldabhängigen Sensor (2) und einem Magneten (1), die zu beiden Seiten einer weichmagnetischen Zwischenlage (4) angeordnet sind. Die weichmagnetische Zwischenlage (4) ist so dimensioniert, daß sie in einer Schaltstellung gesättigt ist und ein zum Schalten ausreichendes Feld am Ort des magnetfeldabhängigen Sensors (2) zur Verfügung steht. Vorteilhafte Anwendungen sind Beschleunigungsschalter oder Kippschalter, bei denen unmittelbar nach Beginn der Schaltbewegung ein Schaltimpuls ausgelöst werden soll.

## Beschreibung

Die Erfindung betrifft einen magnetischen Schalter, bestehend aus einem magnetischen Sensor, der abhängig von dem Erreichen einer bestimmten Schaltfeldstärke sein Ausgangssignal ändert, sowie aus einem Magneten, dessen Entfernung vom Sensor die Schaltstellung des Sensors, d. h. die Größe des Ausgangssignals, bestimmt.

Ein magnetischer Sensor, bestehend aus einem weichmagnetischen Kern mit Spule, der ein elektrisches Ausgangssignal abhängig von der Einwirkung eines Magnetfeldes in Richtung des weichmagnetischen Kerns liefert, ist aus DE-A1 32 41 018 bekannt. Ein derartiger magnetisch arbeitender Sensor wird bei Annäherung sowie bei Entfernung eines Magneten unterschiedliche elektrische Ausgangssignale abgeben, die für die verschiedensten Zwecke ausgewertet werden können. Daher ist dieser magnetisch arbeitende Sensor unter anderem auch als magnetischer Schalter einsetzbar, wenn mit Hilfe der Auswerteschaltung überwacht wird, ob ein bestimmter Schwellwert des einwirkenden Magnetfeldes über- bzw. unterschritten ist.

In gleicher Weise wie der dort beschriebene magnetische Sensor können auch andere Sensoren, die auf unterschiedliche Magnetfelder reagieren, verwendet werden, um einen magnetischen Schalter darzustellen. Solche Sensoren sind zum Beispiel Sensoren, die auf der Ausnutzung des sogenannten Halleffektes beruhen.

Bei Verwendung einer derartigen, aus magnetischem Sensor und Dauermagnet bestehenden Anordnung als Schalter muß jedoch - um eine ausreichende Schaltsicherheit zu erhalten - der Magnet relativ zum magnetischen Sensor um eine Wegstrecke hin oder zurück bewegt und sichergestellt werden, daß der für das Schalten vorgesehene Schwellwert des Sensors dabei über- bzw. unterschritten wird.

Für manche Anwendungen ist es vorteilhaft, einen magnetischen Schalter zu haben, der mit einem möglichst kleinen Weg des Magneten auskommt, um den Schaltvorgang auszulösen.

Bei der eingangs beschriebenen Anordnung würde das bedeuten, daß der Magnet exakt in Nähe des Schaltpunktes justiert werden muß, damit bei einer relativ kleinen Bewegung zum Sensor bzw. von diesem fort die kritische Schaltfeldstärke am Ort des Sensors durchlaufen wird. Weiterhin muß sichergestellt sein, daß magnetische Fremdfaktoren abgeschirmt sind, da diese den Schaltpunkt verändern können. Aus diesen Gründen ist die bekannte Sensoranordnung für Schaltzwecke nicht besonders gut geeignet, wenn der Schaltvorgang durch eine relativ kleine Bewegung ausgelöst werden soll.

Aufgabe der vorliegenden Erfindung ist es nun, einen derartigen magnetischen Schalter anzugeben, bei dem keine Justierprobleme auftreten, der unempfindlich gegenüber Fremdfeldern ist und bei dem trotzdem durch kleinste Bewegungen mit Sicherheit ein Schaltvorgang stattfindet.

Diese Aufgabe wird erfindungsgemäß dadurch gelöst, daß sich zwischen dem Sensor und dem Magneten eine weichmagnetische Zwischenlage befindet, daß der Magnet und/oder ein den magnetischen Fluß des Magneten leitender magnetischer Rückschluß in einer Schaltstellung des Schalters sich an der Zwischenlage abstützt und so dimensioniert ist, daß in einer Schaltstellung die Zwischenlage soweit gesättigt ist, daß ein zum Aktivieren des Sensors ausreichendes Feld durch die Zwischenlage hindurchtritt und daß zum Schalten in die andere Schaltstellung der Magnet oder der magnetische Rückschluß so bewegt wird, daß sich die Sättigung der weichmagnetischen Zwischenlage vermindert, so daß durch die unterhalb der Sättigungsgrenze für den Magnetfluß in der weichmagnetischen Zwischenlage wesentlich erhöhte Permeabilität der Sensor von dem Magnetfeld des Magneten abgeschirmt wird.

Ausführungs- und Anwendungsbeispiele sind in den Figuren dargestellt.
Fig. 1 zeigt im Prinzip die Anordnung von Sensor, Magnet und Zwischenlage;
Fig. 2 eine Abwandlung dieser Anordnung, bei der zum Schalten nicht der Magnet, sondern ein weichmagnetischer Ring bewegt wird;
Fig. 3 eine Anordnung, bei der die Kippbewegung einer Halterung zur Bewegung des Magneten ausgenutzt wird;
Fig. 4 eine Anordnung, bei der der magnetische Schalter zur Erfassung eines Beschleunigungswertes Verwendung findet;
Fig. 5 ein Diagramm, das die Abhängigkeit des Schaltpunktes von den wirksamen Entfernungen zwischen Magnet und Zwischenlage sowie Sensor und Zwischenlage darstellt, und die
Fig. 6 und 7 die magnetischen Feldlinien, wie sie sich bei unterschiedlicher Entfernung des Magneten von der Zwischenlage einstellen.

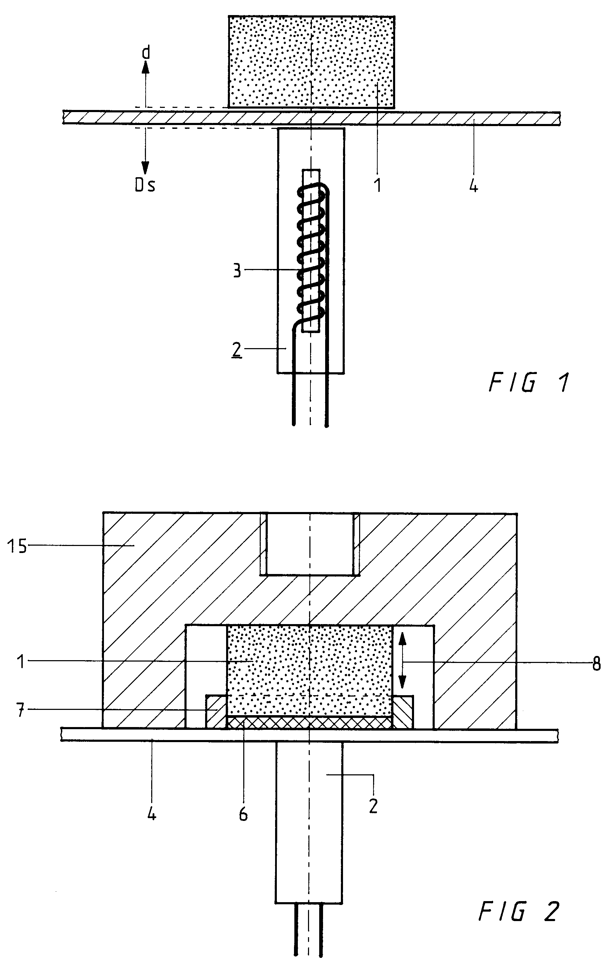

In Fig. 1 ist die Anordnung ohne umgebende Halterungen usw. im Prinzip dargestellt. Ein Magnet 1 und ein Sensor 2, der beispielsweise ein Hallgenerator oder auch ein Sensor mit einem bewickelten weichmagnetischen Streifen 3 sein kann, sind zu beiden Seiten einer weichmagnetischen Zwischenlage 4 angeordnet. In Fig. 1 wird angenommen, daß der Magnet 1 und die weichmagnetische Zwischenlage hinsichtlich des weichmagnetischen Materials und der Dicke der Zwischenlage so dimensioniert sind, daß bei anliegendem Magenten 1 an der Zwischenlage 4 die Zwischenlage 4 soweit gesättigt ist, daß ein ausreichendes Magnetfeld diese Zwischenlage durchdringt, so daß der Schaltpunkt des Sensors 2, der in einer nicht dargestellten Auswerteeinrichtung ausgewertet wird, überschritten wird.

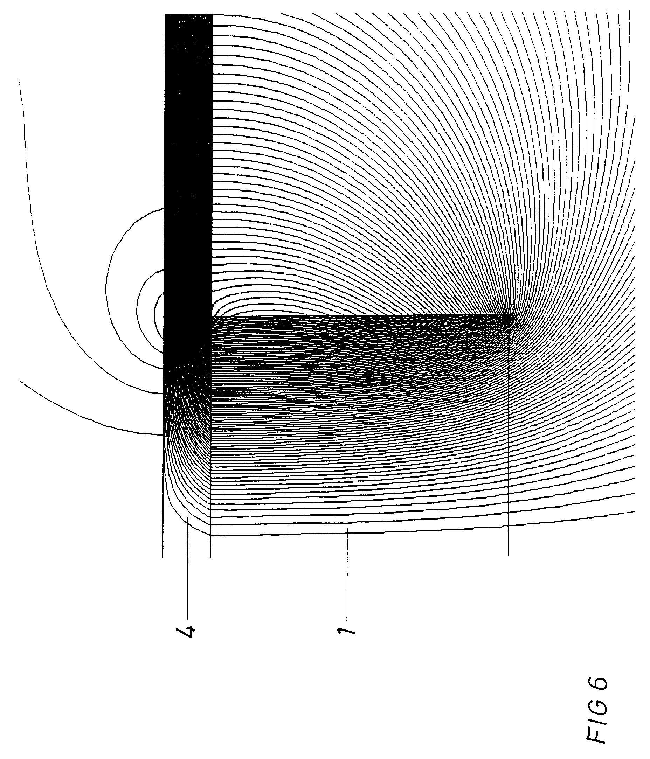

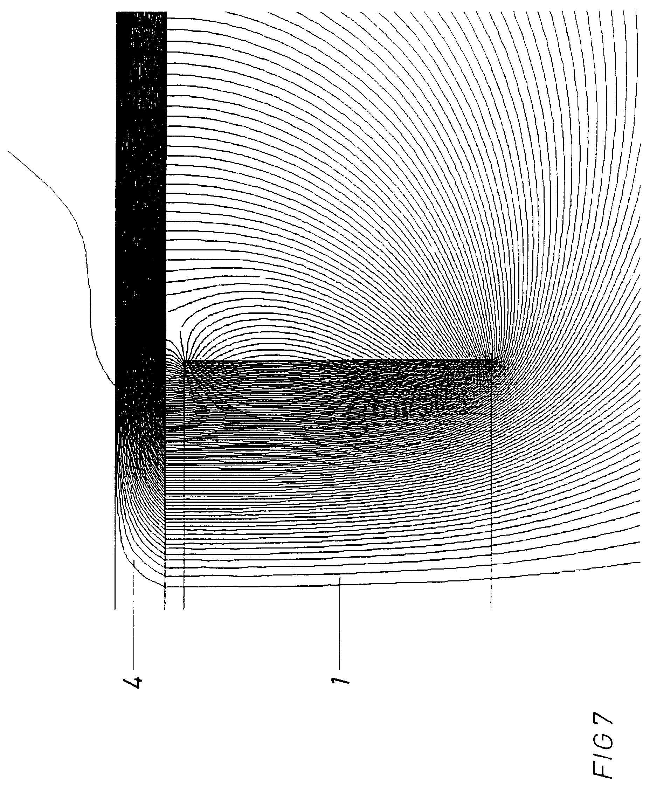

Bei Entfernung des Magneten 1 von der Zwischenlage 4 schließen sich ein Teil der aus dem Magneten austretenden Kraftlinien außerhalb der Zwischenlage 4, wie aus den Fig. 6 und 7 zu erkennen ist. Hierbei zeigt Fig. 6 das Magnetfeld bei anliegendem Magneten an der Zwischenlage und Fig. 7 die Verhältnisse, wenn ein kleiner Luftspalt zwischen Magnet und Zwischenlage besteht. Man sieht, daß schon bei sehr kleinem Abstand zwischen Magnet 1 und Zwischenlage 4 das Verhältnis der jenseits des Magneten 1 aus der Zwischenlage 4 austretenden Kraftlinien sich auf einen Bruchteil vermindert. Da die Dichte der Kraftlinien ein Maß für die Feldstärke ist, erkennt man hieraus auch, daß eine kleine Bewegung des Magneten 1 eine starke Verminderung der Feldstärke auf der dem Magneten 1 abgewandten Seite der weichmagnetischen Zwischenlage bewirkt.

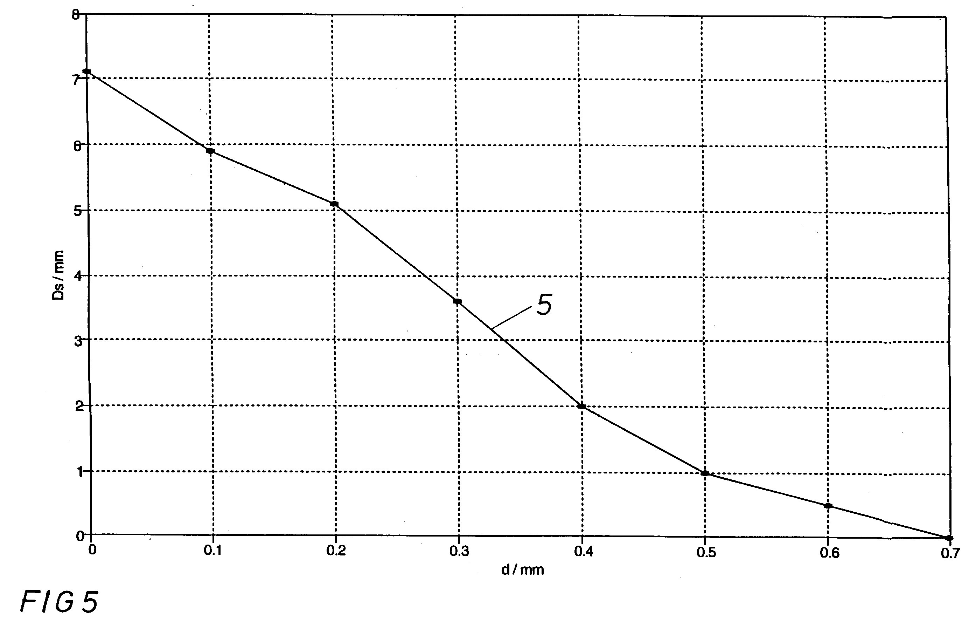

Quantitativ ist dies in Fig. 5 dargestellt. Hier ist die Entfernung des wirksamen Meßpunktes des Sensors 2 von der Zwischenlage 4 mit Ds auf der Ordinate und die Entfernung des Magneten 1 von der Zwischenlage 4 mit d auf der Abszisse bezeichnet. Die Kurve 5 verbindet in den Diagramm Punkte, bei denen die beispielsweise im Sensor 2 eingestellte Schaltfeldstärke erreicht wird. Dies bedeutet, daß der Sensor 2 unterhalb der Kurve 5 eingeschaltet ist (Magnetfeld vorhanden) und oberhalb dieser Kurve in den ausgeschalteten Zustand (Magnetfeld nicht vorhanden) übergeht. Diese Kurve zeigt die relative Unempfindlichkeit für die Justierung des Sensors 2, da beispielsweise ein Abstand Ds zwischen 2 und 5 mm den Schaltpunkt nur um 0,2 mm in Bezug auf den Abstand d (Entfernung des Magneten 1 von der Zwischenlage 4) verändert. Wenn der Magnet 1 oder ein damit fest verbundenes Teil sich in der einen Schaltstellung an der Zwischenlage 4 abstützt, so erreicht man damit eine definierte Ausgangslage für den zurückzulegenden Schaltweg, so daß die Anordnung sowohl im Hinblick auf die Justierung des Sensors 2 als auch auf diejenige des Magneten 1 unempfindlich ist.

Der anhand der Fig. 1 beschriebene Effekt läßt sich auch erreichen, wenn nicht der Magnet 1, sondern ein damit im Zusammenhang stehendes weichmagnetisches Teil verschoben wird. Hier ist der Magnet 1 an einem Gehäuse 15 befestigt, das sich auf der weichmagnetischen Zwischenlage 4 abstützt. Zwischen dem Magneten 1 und der weichmagnetischen Zwischenlage ist eine zusätzliche weichmagnetische Platte 6 vorgesehen. Beide werden von einem ebenfalls aus weichmagnetischem Material bestehenden Ring 7 umgeben, der in Richtung der Pfeile 8 bewegt werden kann.

In der gezeichneten Stellung des weichmagnetischen Ringes 7 wird ein Teil des Magnetflusses des Magneten 1 über die weichmagnetische Platte 6 und den Ring 7 von der Zwischenlage 4 ferngehalten, so daß der Sensor 2 sich in dem Schaltzustand "kein magnetisches Feld" befindet. Verschiebt man den weichmagnetischen Ring auf dem Magneten 1 in Fig. 2 nach rechts, so tritt der Fluß des Magneten durch die weichmagnetische Platte nahezu vollständig in die weichmagnetische Zwischenlage 4 ein, so daß diese gesättigt wird und das hindurchtretende Streufeld auf den Sensor 2 wirkt und diesen in die Schaltstellung "Magnetfeld vorhanden" schaltet.

Auch hier wird also der Sättigungseffekt in der magnetischen Zwischenlage 4 ausgenutzt, um durch kleine Bewegungen aus einer definierten Ausgangslage eine zuverlässige Schaltung des magnetischen Schalters zu erreichen.

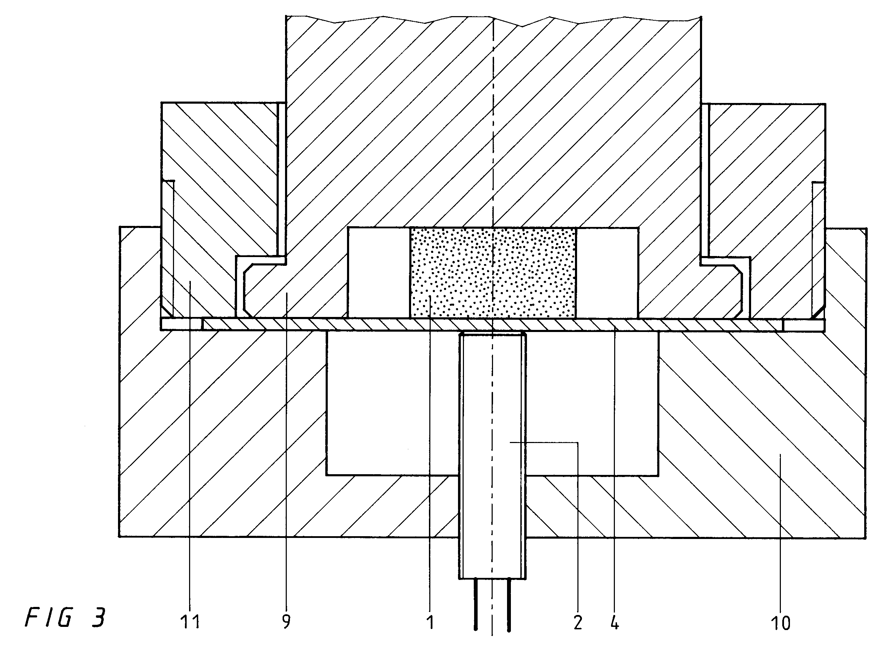

Angewendet werden kann ein derartiger magnetischer Schalter beispielsweise in dem Schalthebel eines Kraftfahrzeugs, wenn dieses mit einer automatischen Kupplungssteuerung ausgerüstet werden soll und diese Steuerung ein Signal benötigt, ob der Schalthebel betätigt wird oder nicht. Eine derartige Steuerung zeigt Fig. 3. Die Halterung 9 des Magneten 1 ist hier beispielsweise der Schaft des Schalthebels, der sich nach unten in dem Halteteil 10 für den Sensor 2 fortsetzt. Die weichmagnetische Zwischenlage 4 wird zwischen dem Halteteil 10 und Führungsteilen 11 und 12 gehalten und die Halterung 9 ist so ausgeführt, daß sie um einen bestimmten kleinen Winkel gekippt werden kann. Hierdurch entfernt sich der Magnet ein kleines Stück von der Zwischenlage 4, so daß eine nahezu unmerkliche Kippbewegung ausreicht, um eine zuverlässige Schaltung des magnetischen Sensors 2 auszulösen.

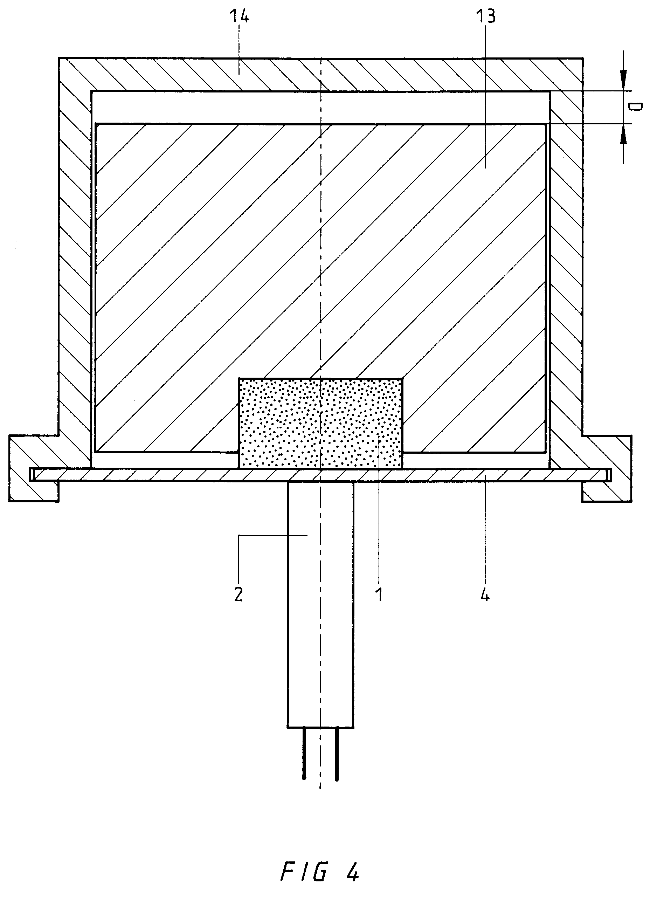

Eine weitere Anwendungsmöglichkeit besteht in einem Beschleunigungssensor nach Fig. 4. Hier ist der Magnet 1 in eine Masse 13 eingelassen, auf die die Beschleunigung wirken soll. Diese Masse ist in einem Gehäuse 14 geführt, das als Führungshülse für die Masse wirkt und eine Verschiebung der Masse 13 mit dem Magneten 1 um einen Betrag D erlaubt.

Wenn nun eine Beschleunigungskraft senkrecht zur Zwischenlage 4 auf die Anordnung wirkt, so wird bei Erreichen eines bestimmten Mindestbetrages dieser Kraft die Haltekraft des Magneten 1 an der magnetischen Zwischenlage 4 überwunden. Der Magnet entfernt sich von der Zwischenlage 4 und der Sensor 2 schaltet.

Dies zeigt einen weiteren Vorteil des erfindungsgemäßen magnetischen Schalters. Eine Betätigung findet nur statt, wenn eine bestimmte Kraft (Haltekraft des Magneten) überschritten wird. Diese Kraft kann ebenfalls durch Dimensionierung des Magneten und der Zwischenlage 4 in Verbindung mit der Masse 13 eingestellt werden. Abhängig von der Einbaulage der in Fig. 4 dargestellten Anordnung kann der Beschleunigungssensor abhängig von verschiedenen Beschleunigungsrichtungen, z. B. bei einem Fahrzeugunfall beim Kippen (Verminderung der Erdbeschleunigung) eingesetzt werden.

## Patentansprüche

1. Magnetischer Schalter, bestehend aus einem magnetischen Sensor (2), der abhängig von dem Erreichen einer bestimmten Schaltfeldstärke sein Ausgangssignal ändert, sowie aus einem Magneten (1), dessen Entfernung vom Sensor (2) die Schaltstellung des Sensors (2), d.h. die Größe des Ausgangssignals, bestimmt, **dadurch gekennzeichnet**, daß sich zwischen dem Sensor (2) und dem Magneten (1) eine weichmagnetische Zwischenlage (4) befindet, daß der Magnet (1) und/oder ein den magnetischen Fluß des Magneten (1) leitender magnetischer Rückschluß in einer Schaltstellung des Schalters sich an der Zwischenlage (4) abstützt und so dimensioniert ist, daß in einer Schaltstellung die Zwischenlage (4) soweit gesättigt ist, daß ein zum Aktivieren des Sensors (2) ausreichendes Feld durch die Zwischenlage (4) hindurchtritt und daß zum Schalten in die andere Schaltstellung der Magnet (1) oder der magnetische Rückschluß so bewegt wird, daß sich die Sättigung der weichmagnetischen Zwischenlage (4) vermindert, so daß durch die unterhalb der Sättigungsgrenze für den Magnetfluß in der weichmagnetischen Zwischenlage (4) wesentlich erhöhte Permeabilität der Sensor (2) von dem Magnetfeld des Magneten (1) abgeschirmt wird.

2. Magnetischer Schalter nach Anspruch 1, **dadurch gekennzeichnet**, daß der Magnet (1) in einer Schaltstellung des Schalters an der Zwischenlage (4) anliegt und zum Schalten in die andere Schaltstellung von dieser entfernt wird.

3. Magnetischer Schalter nach Anspruch 1, **dadurch gekennzeichnet**, daß der Sensor (2) auf der dem Magneten (1) gegenüberliegenden Seite an der weichmagnetischen Zwischenlage (4) anliegt.

4. Magnetischer Schalter nach Anspruch 1, **dadurch gekennzeichnet**, daß die magnetische Zwischenlage (4) ein Eisenblech ist.

5. Magnetischer Schalter nach Anspruch 1 oder 2, **dadurch gekennzeichnet**, daß der Magnet (1) mit einer Halterung (9) verbunden ist und daß die Bewegung des Magneten (1) durch Kippen der Halterung (9) auf der Zwischenlage (4) bewirkt wird.

6. Magnetischer Schalter nach Anspruch 5, **dadurch gekennzeichnet**, daß eine Haltekonstruktion zur Begrenzung der Kippfähigkeit der Halterung (9) vorgesehen ist.

7. Magnetischer Schalter nach Anspruch 1 oder 2, **dadurch gekennzeichnet**, daß der Magnet (1) mit einer in einem Gehäuse (14) geführten Masse (13) verbunden ist, so daß er sich bei Einwirkung von Beschleunigungskräften auf die Masse (13) um einen begrenzten Betrag von der Zwischenlage (4) entfernen kann.

8. Magnetischer Schalter nach Anspruch 1 oder 2, **dadurch gekennzeichnet**, daß beiderseits des Magneten (1) je eine Zwischenlage vorgesehen ist und der Magnet (1) so geführt ist, daß er sich wahlweise an eine oder die andere weichmagnetische Zwischenlage anlegt.
